# EUROPÄISCHE PATENTSCHRIFT

(11) **EP 3 701 276 B1**
(45) Veröffentlichungstag und Bekanntmachung des Hinweises auf die Patenterteilung: **19.04.2023**
(21) Anmeldenummer: 18727717.3
(22) Anmeldetag: 16.05.2018
(51) Int. Cl.: G01R 31/3167

(54) **INTEGRIERTE SCHALTUNG UND ASIC**
INTEGRATED CIRCUIT AND ASIC
CIRCUIT INTÉGRÉ ET ASIC

(30) Priorität: 28.06.2017 DE 102017210851
(43) Veröffentlichungstag der Anmeldung: 02.09.2020
(73) Patentinhaber: Robert Bosch GmbH, 70442 Stuttgart (DE)
(72) Erfinder: BRUCKLACHER, Stefan, 72760 Reutlingen (DE); FIBRANZ, Heiko, 72770 Reutlingen (DE); PEETZ, Roland Johann, 90461 Nuernberg (DE); WIEJA, Thomas, 72810 Gomaringen (DE)
(86) Internationale Anmeldenummer: PCT/EP2018/062717
(87) Internationale Veröffentlichungsnummer: WO 2019/001836

(56) Entgegenhaltungen:
- DE-A1- 10 040 454
- US-B1- 6 367 043
- Subhasish Mitra ET AL: "Special ITC Section 566 IEEE Design & Test of Computers", , 3. November 2005 (2005-11-03), XP055499077, Gefunden im Internet: URL:https://ieeexplore.ieee.org/ielx5/54/3 2926/01541920.pdf?tp=&arnumber=1541920&isn umber=32926 [gefunden am 2018-08-10]

## Beschreibung

Die vorliegende Erfindung betrifft eine integrierte Schaltung und ein ASIC mit einer solchen integrierten Schaltung.

### Stand der Technik

Moderne integrierte Schaltungen wie beispielsweise ASIC bestehen sowohl aus analogen als auch aus digitalen Schaltungen. Diese sind jeweils zu einem Bereich zusammengefasst und auf einem Chip integriert. Durch die kleinen Strukturen des Halbleiterprozesses können insbesondere im digitalen Schaltungsteil sehr komplexe Schaltungen erzeugt werden. Um diese Schaltungen nach der Fertigung prüfen zu können, werden typischerweise spezielle Testschaltungen integriert, wie beispielsweise Scan-Register oder spezielle Selbsttestschaltungen, letztere auch als BIST (Build in Self Test) geläufig. In der US 6, 367, 043 B1 ist ein BIST-System gezeigt, welches analoge Signale von verschiedenen Knotenpunkten eines Schaltkreises diekretisiert. Im Bereich der digitalen Schaltung kann man dadurch nahezu 100 % der Fertigungsfehler finden. Auch im Bereich der analogen Schaltung können Testschaltungen realisiert werden. Dabei ist jedoch die Testabdeckung nicht so hoch wie im Bereich der digitalen Schaltung. In der DE 100 40 454 A1 wird ein Verfahren zum Prüfen eines analogen Bausteins eines einen Mikroprozessorbaustein und einen Speicherbaustein enthaltenen integrierten Schaltungs-Chip gezeigt. Das Verfahren umfasst das Erzeugen eines Prüfmusters durch den Mikroprozessorbaustein, Zuführen des Prüfmusters zum analogen Baustein und das Bewerten des Antwortsignals durch den Mikroprozessorbaustein. Die Veröffentlichung Mitra et. Al. "Special ITC Section 566 IEEE Design & Test of Computers", 3. November 2005 (2005-11-03), XP0554990077, Gefunden im Internet: URL:https://ieeexplore.ieee.org/ielx5/54/32926/01541920.pdf?tp=&arnumber=15 41920&isnumber=32926 zeigt eine spezielle Zusammenfassung von Signalen.

Von dem Digitalteil ausgehend werden mittels Steuerleitungen beispielsweise Treiber oder Trimmbits im analogen Schaltungsbereich angesteuert. Bei modernen Chips können dabei mehrere hundert dieser Steuerleitungen vorliegen.

Insbesondere das Prüfen der fehlerfreien Funktion solcher Steuerleitungen kann sehr schwierig sein und auch viel Zeit in Anspruch nehmen. Dies kann sogar dazu führen, dass ein Prüfen der Steuerleitungen wirtschaftlich unmöglich wird. Die Problematik kann dabei an einem konkreten Beispiel erläutert werden. Bei einer Bandgap-Schaltung werden mittels fünf Steuerleitungen fünf zugeordnete Trimmbits für eine genau abgeglichene Spannung eingestellt. Für jede Konfiguration der Trimmbits kann dabei eine entsprechende analoge Spannung gemessen werden. Die Messung dieser analogen Spannung dauert an einem Tester typischerweise ungefähr 2 ms.

Möchte man die Funktion der Trimmbits prüfen, so kann man sechs Messungen durchführen. In einer ersten Messung sind beispielsweise alle Trimmbits auf "0" gesetzt und dann wird jeweils immer ein Bit auf "1" gesetzt. Dies ergibt dann eine Gesamttestdauer von 12 ms. Rechnet man dies auf zum Beispiel hundert Steuerleitungen hoch, ergibt sich dadurch eine Zeit von 600 ms, was dann jedoch einen großen Anteil der gesamten veranschlagten Testzeit zum Test eines gesamten Chips veranschlagt.

### Offenbarung der Erfindung

Erfindungsgemäß wird eine integrierte Schaltung gemäß Anspruch 1 zur Verfügung gestellt.

Bevorzugt entspricht das mittels der Testleitung zurückgeführte oder zurückführbare Signal dem über die Steuerleitung übertragenen Steuersignal oder aber auch einem abgewandelten Steuersignal wie beispielsweise einem verstärkten, verzögerten oder auch abgeschwächten Steuersignal. Analoge und digitale Schaltungsbereiche, welche räumlich voneinander getrennt, jedoch in einer integrierten Schaltung oder einem Chip integriert sind, werden häufig auch als Mixed-Signal-Systeme oder Mixed-Signal-Schaltkreise bezeichnet.

Die erfindungsgemäße integrierte Schaltung hat den Vorteil, dass ein digitaler Test des Digitalwerts eines Signals typischerweise deutlich schneller ist als eine analoge Messung im analogen Schaltungsbereich. Das Zurückführen des Signals zwecks Prüfung im digitalen Schaltungsbereich ermöglicht demnach eine deutlich schnellere Prüfung der Steuerleitungen im Vergleich zu der in der Einleitung beispielhaft beschriebenen analogen Messung von Spannungswerten. Beispielsweise kann der Digitalteil eines Chips mit 50 MHz geprüft werden. Selbst in langsameren Anwendungen wie zum Beispiel zur Steuerung von Trimmbits, da hierbei nur geringe Geschwindigkeitsanforderungen benötigt werden, kann beispielsweise mit 10 MHz geprüft werden, was einer Testzeit je Digitalwert von 100 ns entspricht. Dies liegt deutlich unterhalb der Testzeit einer analogen Spannung von 2 ms und macht damit nur einen Bruchteil der Testzeit aus. Solche Zahlenbeispiele sind dabei nur beispielhaft und hängen dabei unter anderem vom Halbleiterprozess, der Anwendung oder dem Aufbau der integrierten Schaltung beziehungsweise des Chips ab.

Bevorzugt umfasst die Steuerleitung einen ersten Treiber mit Pegelwandler. Dies ermöglicht eine Anpassung, insbesondere ein Anheben, des Spannungspegels für entsprechende Anwendungen im analogen Schaltungsbereich. Beispielsweise kann der Pegel von 1,2 V auf eine Verbraucherspannung von zum Beispiel 3 V hochgestellt werden. Die Positionierung kann dabei sowohl im analogen Schaltungsbereich, aber auch alternativ im digitalen Schaltungsbereich liegen.

Auch kann die Steuerleitung eine vor der Verbindung zur Testleitung positionierte Empfangsschaltung umfassen. Dadurch kann diese Empfangsschaltung ebenfalls mittels der Testleitung geprüft werden. Beispielsweise kann die Empfangsschaltung mindestens einen Inverter, ein Schmitt-Trigger oder eine andere logische Schaltung sein.

Vorteilhaft umfasst die Testleitung einen zweiten Treiber mit Pegelwandler. Hierbei kann der Spannungspegel beispielsweise verringert werden, sodass keine Überspannung im digitalen Schaltungsbereich erzeugt wird, sodass keine Schädigung hervorgerufen wird.

Die integrierte Schaltung umfasst N ≥ 2 Steuerleitungen zum Übertragen von jeweiligen Steuersignalen von der digitalen Schaltung in die analoge Schaltung, wobei die analoge Schaltung ferner eine Datenkomprimierungsschaltung umfasst, welche zur Kompression von über die Steuerleitungen übertragenen Steuersignalen in ein komprimiertes Testsignal ausgebildet ist, wobei die Testleitung mit der Datenkomprimierungsschaltung elektrisch leitfähig verbunden ist und wobei mittels der Testleitung ein komprimiertes Testsignal zwecks Prüfung des Digitalwerts des Testsignals zur Testauswertungseinheit zurückgeführt wird. In anderen Worten ausgedrückt ist das komprimierte Testsignal mittels der Testleitung zur Testauswertungseinheit zum Prüfen des Digitalwerts des Testsignals zurückführbar. In noch anderen Worten ausgedrückt ist die Testleitung zum Zurückführen des komprimierten Testsignals zur Testauswertungseinheit zum Prüfen des Digitalwerts des Testsignals ausgebildet. Vorteilhaft kann damit die Anzahl der zurückführenden Testleitungen deutlich reduziert werden. Auch die Anzahl der Treiber mit Pegelwandler kann demnach entsprechend reduziert werden. Statt also einer Verdopplung der Leitungen durch die Testleitungen wird nur eine weitere Testleitung benötigt. Der schaltungstechnische Aufwand wird dadurch deutlich verringert.

Bevorzugt umfasst die Datenkomprimierungsschaltung mindestens ein Logik-Gatter. Damit lassen sich Datenkomprimierungen besonders einfach und effizient erzielen.

Noch bevorzugter umfasst die Datenkomprimierungsschaltung mindestens ein EXOR-Gatter. Das EXOR-Gatter zeigt dabei nur dann einen hohen Pegel am Ausgang, wenn die beiden Eingänge einen voneinander unterschiedlichen Pegel aufweisen. Typischerweise kann ein EXOR-Gatter aus verschiedenen Logik-Gattern aufgebaut sein, welche auch von der Erfindung umfasst sind.

In einer bevorzugten Ausführungsvariante weist die Datenkomprimierungsschaltung N-1 EXOR-Gatter und 1≤n≤N-1, wobei für n≥2 ein erster Eingang des n-ten EXOR-Gatters mit dem Ausgang des (n-1)-ten EXOR-Gatters und ein zweiter Eingang des n-ten EXOR-Gatters mit der (n+1)-ten Steuerleitung elektrisch leitfähig verbunden ist, wobei für n=1 der erste Eingang des 1-ten EXOR-Gatters mit der 1-ten Steuerleitung und der zweite Eingang des 1-ten EXOR-Gatters mit der 2-ten Steuerleitung elektrisch leitfähig verbunden ist, und wobei für n=(N-1) ferner der Ausgang des (N-1)-ten EXOR-Gatters mit der Testleitung zum Zurückführen des komprimierten Testsignals verbunden ist. Hiermit können ein effizientes Komprimieren und auch ein schnelles, systematisches Durchprüfen der Steuerleitungen mittels eines einfachen Prüfschemas erfolgen. Dies kann beispielsweise durch ein sukzessives Hochstellen der Steuersignale auf einen hohen Pegel beziehungsweise einer "1" mit darauf folgendem Zurückstellen auf den niedrigen Pegel beziehungsweise "0" erfolgen. Wenn alle Steuerleitungen auf "0" liegen, so ist das Testsignal am Ausgang der Datenkomprimierungsschaltung auch "0". Wenn genau ein beliebiges Steuersignal auf "1" gestellt beziehungsweise einen hohen Pegel aufweist, so liegt das komprimierte Testsignal am Ausgang der Datenkomprimierungsschaltung auch auf "1" beziehungsweise hat einen hohen Pegel. Bei erfolgreichem Abgleich dieser erwarteten Digitalwerte durch die Testauswertungseinheit werden das korrekte Übertragen des Steuersignals und damit die Steuerleitungen geprüft. Hierfür sind demnach N+1 Messungen erforderlich, wobei zwischen diesen Messungen zusätzlich auch der niedrige Pegel geprüft werden kann.

Vorteilhaft kann die analoge Schaltung eine Mehrzahl von R Datenkomprimierungsschaltungen mit R≥2 umfassen, wobei jede r-te Datenkomprimierungsschaltung, mit 1≤r≤R, mit einer Mehrzahl von Steuerleitungen elektrisch leitfähig verbunden und dazu ausgebildet ist, die über diese Steuerleitungen übertragenen Steuersignale in ein r-tes Testsignal zu komprimieren. Bei hoher Anzahl von Steuerleitungen, zum Beispiel für N=150, kann das Komprimieren der Steuersignale zeitlich aufwendig werden. Vorteilhaft wird durch die beschriebene Gruppierung, das heißt eine Aufteilung der Steuerleitung in einzelne Gruppen von Steuerleitungen, die Zeit zum Komprimieren reduziert, da die Komprimierung der verschiedenen Komprimierungseinheiten parallel erfolgen kann und jeweils entsprechend nur weniger als N Steuersignale komprimiert werden müssen.

Ferner kann die integrierte Schaltung eine Mehrzahl von R Testleitungen umfassen, wobei jede r-te Testleitung mit der r-ten Datenkomprimierungsschaltung elektrisch leitfähig verbunden ist und komprimierte r-te Testsignale von der analogen Schaltung zu der Testauswertungseinheit zurückführt. In anderen Worten ausgedrückt ist die r-te Testleitung zum Zurückführen des r-ten komprimierten Testsignals zu einer Testauswertungseinheit zum Prüfen des Digitalwerts des r-ten Testsignals ausgebildet. Hierbei kann beispielsweise eine einzige Testauswertungseinheit vorgesehen sein, die alle Testsignale prüft, oder aber auch je Testleitung eine Testauswertungseinheit bereitgestellt sein. Vorteilhaft können dadurch die Testsignale auch parallel geprüft werden, was insbesondere bei einer hohen Anzahl von Steuerleitungen die Testzeit reduziert.

Ferner umfasst die Erfindung eine anwendungsspezifische integrierte Schaltung, ASIC, welche eine integrierte Schaltung nach einem der obigen Ausführungen umfasst.

Ferner umfasst die Erfindung einen Chip, auf welchem eine integrierte Schaltung oder ein ASIC nach vorherigen Ausführungen integriert ist.

Vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 eine integrierte Schaltung nach einer ersten Ausführungsvariante,
Figur 2 eine integrierte Schaltung nach einer zweiten Ausführungsvariante, und
Figur 3 eine integrierte Schaltung nach einer dritten Ausführungsvariante.

### Ausführungsformen der Erfindung

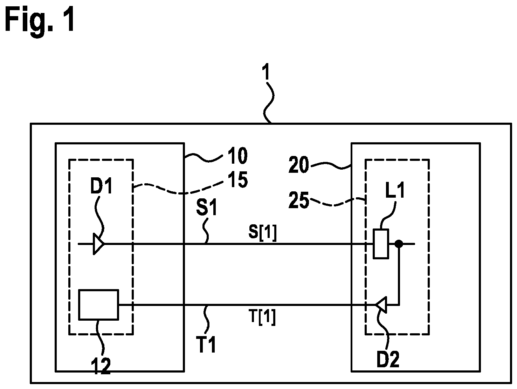

In der Figur 1 ist eine integrierte Schaltung 1 nach einer ersten Ausführungsvariante gezeigt. Die integrierte Schaltung 1 umfasst dabei einen digitalen Schaltungsbereich 10, welcher eine digitale Schaltung 1 umfasst. Ferner umfasst die integrierte Schaltung 15 einen analogen Schaltungsbereich 20, welcher eine analoge Schaltung 25 umfasst. Der analoge Schaltungsbereich ist dabei vom digitalen Schaltungsbereich 10 räumlich getrennt.

Ferner umfasst die integrierte Schaltung 1 eine Steuerleitung S1 zum Übertragen von einem Steuersignal S[1] von der digitalen Schaltung in die analoge Schaltung 25. Dazu ist die Steuerleitung S1 elektrisch leitfähig mit der analogen Schaltung 25 und der digitalen Schaltung 15 verbunden. Ferner umfasst die integrierte Schaltung 1 eine Testauswertungseinheit 12, welche im digitalen Schaltungsbereich 10 integriert ist. In dieser Ausführungsform ist die Testauswertungseinheit 12 dabei lediglich rein beispielhaft auch innerhalb der digitalen Schaltung 15 integriert. Des Weiteren umfasst die integrierte Schaltung 1 eine Testleitung T1. Diese Testleitung T1 ist innerhalb des analogen Schaltungsbereichs 20 mit der Steuerleitung S1 elektrisch leitfähig verbunden. Ferner ist die Testleitung T1 elektrisch leitfähig mit der Testauswertungseinheit 12 verbunden. Die Testauswertungseinheit 12 ist dabei dazu ausgebildet, einen Digitalwert eines über die Testleitung T1 zurückgeführten Signals zu prüfen.

Über die Steuerleitung S1 kann beispielsweise mittels des digitalen Steuersignals ein Trimmbit, eine lokale digitale Logik oder ein Transistor im analogen Schaltungsbereich 20 angesteuert werden. Eine digitale Logik kann beispielsweise auch Register umfassen. Aber auch andere elektronische Bausteine kommen in Betracht, welche über digitale Steuersignale gesteuert werden können.

Bevorzugt entspricht dabei das mittels der Testleitung T1 zurückgeführte oder zurückführbare Signal dem über die Steuerleitung übertragenen Steuersignal S1. Aber auch ein abgewandeltes Steuersignal wie beispielsweise ein verstärktes, verzögertes oder auch abgeschwächtes Steuersignal wie beispielsweise ein durch eine digitale Logik im Analogteil verändertes oder umcodiertes Signal kann zur Prüfung zurückgeführt werden.

Das Prüfen des korrekt übertragenen Steuersignals S[1] erfolgt demnach nicht im analogen Schaltungsbereich 20, sondern im digitalen Schaltungsbereich 10. Die Testzeit zum Testen des Digitalwerts des zurückgeführten Signals im digitalen Schaltungsbereich 10 kann beispielsweise bei Frequenzen von 10 MHz entsprechend 100 ns betragen, was deutlich schneller ist als das Messen eines analogen Spannungswertes, welcher beispielsweise im Größenordnungsbereich von 2 ms liegt. Diese Zahlenbeispiele sind nur beispielhaft und können von dem Halbleiterprozess, der konkreten Anwendung der Steuersignale, dem Aufbau des Chips beziehungsweise der integrierten Schaltung abhängen.

In einer ersten Ausführungsform kann das Steuersignal S[1] über die Testleitung T1 zur Testauswertung geführt werden. Dadurch kann die korrekte Übertragung des Steuersignals S[1] in den analogen Bereich überprüft werden. Eine Prüfung der Steuerleitung S1 kann dabei wie folgt erfolgen. Das Steuersignal S[1] der Steuerleitung S1 wird auf einen Signalwert von "0", das heißt auf den niedrigen Pegel, gelegt, und in den analogen Schaltungsbereich 20, beziehungsweise in die analoge Schaltung 25, übertragen. Die Testauswertungseinheit 12 überprüft dann, ob das über die Testleitung T1 zurückgeführte Steuersignal S[1] durch Prüfung des Digitalwerts ebenfalls den Digitalwert "0" aufweist. Daraufhin kann das Steuersignal S[1] der Steuerleitung S1 auf "1", das heißt auf den hohen Pegel, hochgestellt beziehungsweise hochgezogen werden. Dann wird mittels der Testauswertungseinheit 12 entsprechend geprüft, ob der Digitalwert des über die Testleitung T1 zurückgeführten Steuersignals S[1] ebenfalls den Wert "1" aufweist. Ist dies der Fall, so ist die Steuerleitung S1 erfolgreich geprüft.

Eine Messung einer Steuerleitung S1 bei einer Frequenz von 10 MHz dauert demnach lediglich 100 ns. Im Vergleich zum Stand der Technik, siehe dazu die Einleitung, kann somit ein deutlicher Zeitgewinn erzielt werden. Dieser Zeitgewinn kann dabei beispielsweise zum Testen der anderen Schaltungskomponenten beziehungsweise Schaltungsbausteinen in der integrierten Schaltung 1 oder auf dem Chip verwendet werden.

Ein Signalwert des Steuersignals von "1" kann dabei rein beispielhaft einer digitalen Spannung von 1,5 V entsprechen, wobei die Erfindung nicht darauf beschränkt ist. Zumeist wird in analogen Schaltungen 25 eine davon abweichende, meist höhere Spannung benötigt, beispielsweise eine Versorgungsspannung von 3 V. Dazu kann die Steuerleitung S1 weiterhin einen ersten Treiber D1 mit Pegelwandler umfassen. Der Treiber D1 unterstützt dabei das Umladen beziehungsweise das Hochziehen von einem niedrigen Pegel auf einen höheren Pegel. Der Pegelwandler bewirkt das Ändern des Spannungspegels auf einen im analogen Schaltbereich von der analogen Schaltung 25 benötigten Spannung, also beispielsweise von 1,5 V auf 3 V. Treiber D1 und Pegelwandler können dabei im digitalen Schaltungsbereich 10 integriert sein, zum Beispiel in dem digitalen Schaltungsbereich 10, in dem die Steuerleitung S1 aus dem digitalen Steuerungsbereich herausgetrieben wird. Alternativ kann der Treiber D1 mit Pegelwandler auch eingangsseitig zum analogen Schaltungsbereich 20 oder im analogen Schaltungsbereich 20 integriert sein. Ferner kann beispielhaft die Steuerleitung S1 eine Empfangsschaltung L1 umfassen, welche vor der Verbindung mit der Testleitung T1 positioniert ist. Bei der Empfangsschaltung L1 kann es sich beispielsweise um zwei Inverter oder aber auch um einen Schmitt-Trigger oder um eine andere digitale Schaltung handeln, wobei die Erfindung nicht darauf beschränkt ist Diese Empfangsschaltung L1 kann dann vorteilhaft wie im folgenden beschrieben mitgeprüft werden.

Auch die Testleitung T1 kann einen zweiten Treiber D2 mit Pegelwandler umfassen. Damit kann beispielsweise ein hochgestellter Spannungspegel auf einen für den digitalen Schaltungsbereich 10 beziehungsweise die digitale Schaltung 15 verträglichen Spannungswert gesenkt werden. Dies schützt beispielsweise den digitalen Schaltbereich oder die digitale Schaltung 15 vor einer zu hohen Spannung. Das über die Testleitung T1 zurückgesandte Signal ist dabei das Testsignal T[1]. Dieses kann sich vom Steuersignal S[1] dann durch einen geringeren Spannungspegel unterscheiden als Folge der Funktion der Pegelwandler, auch Pegelumsetzer genannt.

Eine Prüfung der Steuerleitung S1 mittels dieses zurückgesandten Testsignals T[1] erfolgt dabei wie bereits oben beschrieben. Die Pegel des Steuersignals S[1] werden durchgestellt und dabei geprüft, ob das Testsignal T[1] den gleichen Pegel aufweist. In dieser Ausführungsform wird dabei auch die Schaltung des ersten Treibers D1 mit Pegelwandler mitgeprüft. Bei Ausführungsformen mit zweitem Treiber D2 sowie dazugehörigem Pegelwandler werden auch diese Schaltungen mitgeprüft.

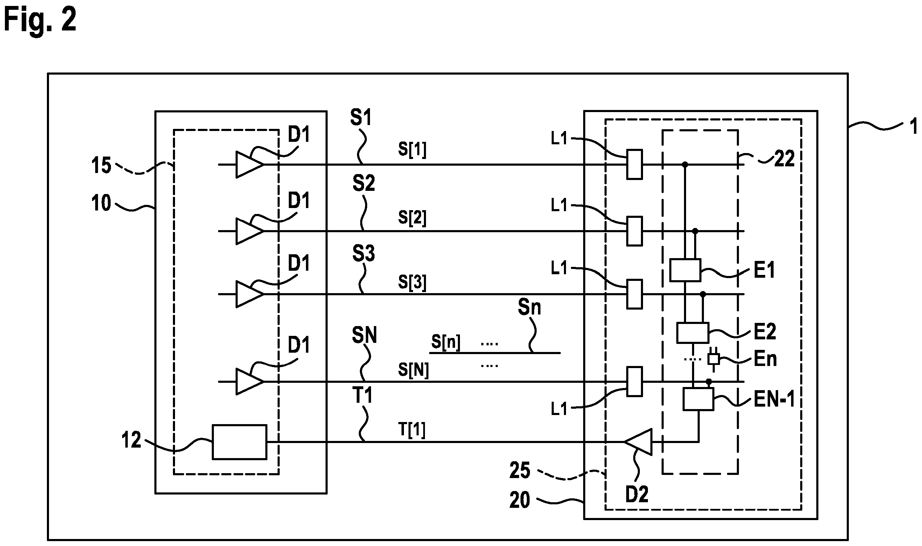

In der Figur 2 ist eine integrierte Schaltung 1 nach einer zweiten Ausführungsform beschrieben. Im Vergleich zur Ausführungsform nach Figur 1 umfasst die integrierte Schaltung 1 eine Mehrzahl N ≥ 2 Steuerleitungen S1, ..., Sn, ..., SN welche jeweils eine elektrisch leitfähige Verbindung zwischen der digitalen Schaltung 15 und der analogen Schaltung 25 ausbilden. Diese N ≥ 2 Steuerleitungen S1, ..., Sn, ..., SN dienen dabei zum Übertragen von N Steuersignalen S[1], ..., S[n], ..., S[N] von der digitalen Schaltung 15 im digitalen Schaltungsbereich 10 in die analoge Schaltung 25 im vom digitalen Schaltungsbereich 10 räumlich getrennten analogen Schaltungsbereich 20. Dabei wird das 1-te Steuersignal S[1] über die 1-te Steuerleitung S1, das 2-te Steuersignal S[2] über die zweite Steuerleitung S2, das 3-te Steuersignal S[3] über die 3-te Steuerleitung S3 zu der analogen Schaltung 25 übertragen. Entsprechend wird das n-te Steuersignal S[n] über die n-te Steuerleitung Sn zu der analogen Schaltung 25 übertragen.

Durch die N ≥ 2 Steuerleitungen können beispielsweise N Trimmbits, N digitale Logiken oder N Transistoren gesteuert werden, wobei die Erfindung nicht auf bestimmte elektronische Bausteine beschränkt ist. Beispielsweise kann es sich bei der analogen Schaltung 25 um eine Bandgap-Schaltung handeln, bei der N Trimmbits zum genauen Abgleichen einer Referenzspannung angesteuert werden. Die Anzahl der Steuerleitungen N kann in dieser Ausführungsform beispielsweise 2, 3, 5, 15, 30 oder aber auch 150 sein, wobei die Erfindung nicht auf diese Beispiele beschränkt ist.

In dieser zweiten Ausführungsform kann die analoge Schaltung 25 eine Datenkomprimierungsschaltung 22 umfassen. Die Datenkomprimierungsschaltung 22 ist dabei elektrisch leitfähig mit den N ≥ 2 Steuerleitungen S1, ..., Sn, ..., SN im analogen Schaltungsbereich 20 oder auch innerhalb der analogen Schaltung 25 elektrisch leitfähig verbunden. Die Datenkomprimierungsschaltung 22 ist dabei dazu ausgebildet, die N Steuersignale S[1], ..., S[n], ..., S[N], welche über N Steuerleitungen S1, ..., Sn, ..., SN in die analoge Schaltung 25 übertragen werden, in ein komprimiertes Testsignal T[1] zu komprimieren beziehungsweise zusammenzufassen. Ferner ist beispielhaft die Testleitung T1 mit dem Ausgang der Datenkomprimierungsschaltung 22 elektrisch leitfähig verbunden. Das komprimierte Testsignal T[1] kann dann über die Testleitung T1 zur Prüfung des Digitalwertes des komprimierten Testsignals T[1] zur Testauswertungseinheit 12 zurückgeführt werden.

Der Vorteil, der mit der Datenkomprimierungsschaltung 22 erzielt wird, liegt mitunter darin, dass die Anzahl der zurückzuführenden Testleitungen auf eine einzige Testleitung T1 beschränkt wird. Auch die Schaltungen für Treiber und Pegelwandler werden entsprechend reduziert. Der schaltungstechnische Aufwand wird demnach von N-1 Testleitungen auf eine Testleitung reduziert.

In dieser bevorzugten Ausführungsvariante umfasst die Datenkomprimierungseinheit 22 Logik-Gatter. Insbesondere umfasst die Datenkomprimierungseinheit 22 ein EXOR-Gatter E1, ..., E2, ..., EN-1. In dieser konkreten Ausführungsform sind beispielhaft dazu N-1 EXOR-Gatter E1, ..., E2, ..., EN-1 miteinander elektrisch leitfähig zusammengeschaltet, was im Folgenden näher beschrieben wird.

Für n≥2, wobei ferner für die N-1 EXOR-Gatter n≤N-1 gilt, ist ein erster Eingang des n-ten EXOR-Gatters En mit dem Ausgang des (n-1)-ten EXOR-Gatter und ein zweiter Eingang des n-ten EXOR-Gatter En mit der (n+1)-ten Steuerleitung (Sn+1) elektrisch leitfähig verbunden. Beispielsweise ist für n=2 der erste Eingang des 2-ten EXOR-Gatters E2 mit dem Ausgang des 1-ten EXOR-Gatters E1 verbunden. Ferner ist der zweite Eingang des 1-ten EXOR-Gatters mit der 3-ten Steuerleitung S3 elektrisch leitfähig verbunden.

Für n=1 ist ferner der erste Eingang des 1-ten EXOR-Gatters E1 mit der 1-ten Steuerleitung S1 und der zweite Eingang des 1-ten EXOR-Gatters E2 mit der 2-ten Steuerleitung S2 elektrisch leitfähig verbunden. Ferner ist der Ausgang des (N-1)-ten EXOR-Gatters (EN-1) mit der Testleitung T1 zum Zurückführen des komprimierten Testsignals T[1] zur Testauswertungseinheit 12 elektrisch leitfähig verbunden.

Alternativ können die EXOR-Gatter auch in Form eines EXOR-Gatter-Baums geschaltet werden, der die Steuerleitungen verknüpft. Auch andere zweckmäßige Ausführungsformen, in denen andere Logik-Gatter wie AND-Gatter und OR-Gatter zum Einsatz kommen, sind von der Erfindung umfasst.

Diese Datenkomprimierungseinheit 22 kann dabei beispielhaft in folgender Weise zum systematischen Prüfen der N Steuerleitungen S1, ..., Sn, ..., SN verwendet werden. Zunächst werden alle Steuersignale S[1], ..., S[n], ..., S[N] auf dem niedrigen Pegel, der "0", eingestellt. Dann muss auch das Testsignal T[1] entsprechend den niedrigen Pegel "0" aufweisen. Dann kann das 1-te Steuersignal S[1] auf den hohen Pegel, die "1", gestellt werden, während die übrigen Steuersignale S[2], ... S[n], ... S[N] den niedrigen Pegel, die "0", aufweisen. Dann müsste das Testsignal T[1] aufgrund der logischen Schaltung der EXOR-Gatter E1, ..., En, ..., EN den hohen Pegel, die "1", aufweisen. Danach wird das 1-te Steuersignal S[1] wieder auf "0" gestellt und folgend das 2-te Steuersignal S[2] auf "1", während wiederum alle übrigen Steuersignale S[1], S[3], ..., S[n], ..., S[N] den niedrigen Pegel, die "0" aufweisen. So kann sukzessive jedes n-te Steuersignal S[n] auf den hohen Pegel, die "1", gestellt werden, während jeweils die übrigen Steuersignale auf dem niedrigen Pegel sind, sodass sich bei korrekter Übertragung des Signals aufgrund der Rückstellung eine alternierende Folge von "1" und "0" für das komprimierte Testsignal T[1] ergibt. Durch das systematische Durchstellen sind dann alle Steuerleitungen S1, ..., Sn, ..., SN einmal geprüft. Bei erfolgreicher Prüfung durch die Testauswertungseinheit 12 sind damit alle Steuerleitungen S1, ..., Sn, ..., SN geprüft.

Auch hier können die Steuerleitungen S1, ..., Sn, ..., SN jeweils Empfangsschaltungen L1 umfassen, welche vor der Datenkomprimierungsschaltung 22 positioniert sind und entsprechend von der Testleitung T1 mitgeprüft werden können.

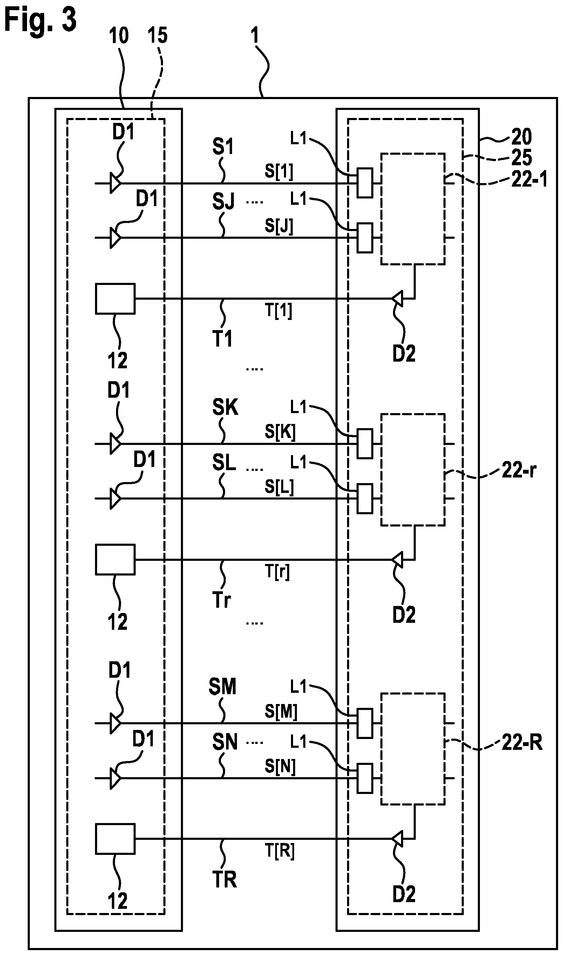

In der Figur 3 ist eine integrierte Schaltung 1 nach einer dritten Ausführungsvariante gezeigt. In dieser Ausführungsform sind dabei ebenfalls N≥2 Steuerleitungen zum Übertragen von N Steuersignalen S[1], ..., S[n], ..., S[N] von der digitalen Schaltung 15 in die analoge Schaltung 25 vorgesehen. Im Unterschied zur zweiten Ausführungsform kann die analoge Schaltung 25 hierbei eine Mehrzahl von R Datenkomprimierungsschaltungen 22-1, ..., 22-r, ..., 22-R mit R≥2 umfassen.

Dabei ist jede r-te Datenkomprimierungsschaltung 22-r, mit 1≤r≤R, mit einer Mehrzahl von Steuerleitungen SK, ..., SL elektrisch leitfähig verbunden, wobei die Anzahl dieser zugeordneten Steuerleitungen SK, ..., SL geringer ist als die Gesamtzahl der N Steuerleitungen. Jede r-te Datenkomprimierungsschaltung 22-r ist in dieser Ausführungsform ferner dazu ausgebildet, die über diese zugeordneten Steuerleitungen SK, ..., SL übertragenen Steuersignale S[K], ..., S[L] in ein r-tes Testsignal T[r] zu komprimieren. Jede r-te Datenkomprimierungsschaltung 22-r ist demnach mit einer jeweiligen Gruppe von Steuerleitungen elektrisch leitfähig verbunden.

In der vorliegenden Ausführungsform ist beispielsweise der 1-ten Datenkomprimierungseinheit 22-1 die 1-te Steuerleitung S1 bis zur J-ten Steuerleitung zugeordnet, wobei das einer Anzahl von J Steuerleitungen S1, ..., SJ entspricht, mit J≥2 und J≤N. Der r-ten Datenkomprimierungseinheit 22-r sind demnach die K-te Steuerleitung SK mit dem zu übertragendem K-ten Steuersignal S[K] bis zur L-ten Steuerleitung SL mit dem zu übertragendem L-ten Steuersignal S[L] zugeordnet, was einer Anzahl von L-K+1 entspricht, wobei L-K+1≥2 und L, K≤N. Der R-ten Datenkomprimierungseinheit 22-R sind demnach die M-te Steuerleitung S[M] bis zur N-ten Steuerleitung zugeordnet, was N-M+1≥2entspricht, wobei N-M+1≥2 und M ≤ N.

Zusammenfassend wird in dieser Ausführungsform der Erfindung demnach die Gesamtheit der N≥ 2 Steuerleitungen S1, ..., Sn, ..., SN derart gruppiert, dass jede der R Datenkomprimierungsschaltungen 22-1, ..., 22-r, ..., 22-R stets weniger als N Steuersignale zu einem jeweiligen komprimierten Testsignal T[1], ..., T[r], ..., T[R] komprimiert. Bei sehr hoher Anzahl von Steuerleitungen, zum Beispiel für N=150, kann das Komprimieren mittels der Komprimierungsschaltung in ein komprimiertes Testsignal entsprechend lange dauern. Der Vorteil dieser Ausführungsform besteht somit darin, dass durch die Gruppierung die Zeit zum Komprimieren reduziert wird und ferner auch parallel komprimiert werden kann.

Dabei kann jede r-te Datenkomprimierungsschaltung 22-r wie im Zusammenhang mit Figur 2 beschrieben ausgebildet sein, was in dieser Figur lediglich aus Gründen der Übersicht nicht explizit ausgeführt ist.

Die integrierte Schaltung 1 nach dieser Ausführungsform kann ferner eine Mehrzahl von R Testleitungen T1, ..., Tr, ..., TR umfassen. Dabei ist jede r-te Testleitung Tr mit der zugeordneten r-ten Datenkomprimierungsschaltung 22-r elektrisch leitfähig verbunden. Die komprimierten r-ten Testsignale T[r] können dann von der analogen Schaltung 25 zu der Testauswertungseinheit 12, welche im digitalen Schaltungsbereich 10 integriert ist, über die entsprechende r-te Testleitung Tr zur Testauswertungseinheit 12 zurückgeführt werden.

Somit können vorteilhaft die verschiedenen Testsignale auch parallel, das heißt zeitgleich, geprüft werden. Dazu können mehrere Testauswertungseinheiten 12 oder alternativ auch nur eine zentrale Testauswertungseinheit 12 in dem digitalen Schaltungsbereich 10 integriert sein.

## Patentansprüche

1. Integrierte Schaltung (1), umfassend:
einen digitalen Schaltungsbereich (10), welcher eine digitale Schaltung (15) umfasst;
einen von dem digitalen Schaltungsbereich (10) räumlich getrennten analogen Schaltungsbereich (20), welcher eine analoge Schaltung (25) umfasst;
eine Steuerleitung (S1) zum Übertragen von einem Steuersignal (S[1]) von der digitalen Schaltung (15) in die analoge Schaltung (25);
eine Testauswertungseinheit (12), welche im digitalen Schaltungsbereich (10) integriert ist;
eine innerhalb des analogen Schaltungsbereichs (20) mit der Steuerleitung (S1) elektrisch leitfähig verbundene Testleitung (T1), welche elektrisch leitfähig mit der Testauswertungseinheit (12) verbunden ist, wobei die Testauswertungseinheit (12) dazu ausgebildet ist, einen Digitalwert eines über die Testleitung zurückgeführten Signals zu prüfen,
**dadurch gekennzeichnet, dass**
die integrierte Schaltung (1) N ≥ 2 Steuerleitungen (S1, ... ,Sn,... ,SN) zum Übertragen von jeweiligen Steuersignalen (S[1], ..., S[n], ..., S[N]) von der digitalen Schaltung (15) in die analoge Schaltung (25) umfasst, wobei die analoge Schaltung (25) ferner eine Datenkomprimierungsschaltung (22) umfasst, welche zur Kompression von über die Steuerleitungen (S1, ... ,Sn,...,SN) übertragenen Steuersignalen (S[1], ..., S[n], ..., S[N]) in ein komprimiertes Testsignal (T[1]) ausgebildet ist, wobei die Testleitung (T1) mit der Datenkomprimierungsschaltung (22) elektrisch leitfähig verbunden ist und wobei mittels der Testleitung (T1) ein komprimiertes Testsignal (T[1]) zwecks Prüfung des Digitalwerts des Testsignals (T[1]) zur Testauswertungseinheit (12) zurückgeführt wird.

2. Integrierte Schaltung (1) nach Anspruch 1, wobei die Steuerleitung (S1) einen ersten Treiber (D1) mit Pegelwandler umfasst.

3. Integrierte Schaltung (1) nach einem der vorherigen Ansprüche, wobei die Steuerleitung (S1) eine vor der Verbindung zur Testleitung (T1) positionierte Empfangsschaltung (L1) umfasst.

4. Integrierte Schaltung (1) nach einem der vorherigen Ansprüche, wobei die Testleitung (T1) einen zweiten Treiber (D2) mit Pegelwandler umfasst.

5. Integrierte Schaltung (1) nach einem der Ansprüche 1 bis 4, wobei die Datenkomprimierungsschaltung (22) mindestens ein Logik-Gatter umfasst.

6. Integrierte Schaltung (1) nach einem der Ansprüche 1 bis 5, wobei die Datenkomprimierungsschaltung (22) mindestens ein EXOR-Gatter (E1, ..., En, ..., EN-1) umfasst.

7. Integrierte Schaltung (1) nach Anspruch 6, mit N-1 EXOR-Gattern (E1, ..., En, ..., EN-1) und 1≤n≤N-1, wobei für n≥2
ein erster Eingang des n-ten EXOR-Gatters (En) mit dem Ausgang des (n-1)-ten EXOR-Gatters (En-1) und ein zweiter Eingang des n-ten EXOR-Gatters (En) mit der (n+1)-ten Steuerleitung (Sn+1) elektrisch leitfähig verbunden ist, wobei für n=1
der erste Eingang des 1-ten EXOR-Gatters (E1) mit der 1-ten Steuerleitung (S1) und der zweite Eingang des 1-ten EXOR-Gatters (E1) mit der 2-ten Steuerleitung (S2) elektrisch leitfähig verbunden ist, und wobei für n=(N-1) ferner der Ausgang des (N-1)-ten EXOR-Gatters (EN-1) mit der Testleitung (T1) zum Zurückführen des komprimierten Testsignals (T[1]) elektrisch leitfähig verbunden ist.

8. Integrierte Schaltung (1) nach einem der vorherigen Ansprüche 1 bis 7, wobei die analoge Schaltung (25) eine Mehrzahl von R Datenkomprimierungsschaltungen (22-1, ..., 22-r, ..., 22-R) mit R≥2 umfasst, wobei jede r-te Datenkomprimierungsschaltung (22-r), mit 1≤r≤R, mit einer Mehrzahl von Steuerleitungen (SK, ..., SL) elektrisch leitfähig verbunden und dazu ausgebildet ist, die über diese Steuerleitungen (SK, .., SL) übertragenen Steuersignale (S[K], ..., S[L]) in ein r-tes Testsignal (T[r]) zu komprimieren.

9. Integrierte Schaltung (1) nach Anspruch 8, wobei die integrierte Schaltung (1) ferner eine Mehrzahl von R Testleitungen (T1, ..., Tr, ..., TR) umfasst, wobei jede r-te Testleitung (Tr) mit der r-ten Datenkomprimierungsschaltung (22-r) elektrisch leitfähig verbunden ist und komprimierte r-te Testsignale (T[r]) von der analogen Schaltung (25) zu der Testauswertungseinheit (12) zurückführt.

10. Anwendungsspezifische integrierte Schaltung, ASIC, welche eine integrierte Schaltung (1) nach einem der Ansprüche 1 bis 9 umfasst.

## Claims

1. Integrated circuit (1), comprising:
a digital circuit area (10) that comprises a digital circuit (15);
an analogue circuit area (20) that is physically separate from the digital circuit area (10) and comprises an analogue circuit (25);
a control line (S1) for transmitting a control signal (S[1]) from the digital circuit (15) to the analogue circuit (25);
a test evaluation unit (12) that is integrated in the digital circuit area (10);
a test line (T1) that is within the analogue circuit area (20), is electrically conductively connected to the control line (S1) and is electrically conductively connected to the test evaluation unit (12), wherein the test evaluation unit (12) is designed to check a digital value of a signal fed back via the test line,
**characterized in that**
the integrated circuit (1) comprises N ≥ 2 control lines (S1,...,Sn,...,SN) for transmitting respective control signals (S[1],...,S[n],...,S[N]) from the digital circuit (15) to the analogue circuit (25), wherein the analogue circuit (25) also comprises a data compression circuit (22) that is designed to compress control signals (S[1],...,S[n],...,S[N]) transmitted via the control lines (S1,...,Sn,...,SN) into a compressed test signal (T[1]), wherein the test line (T1) is electrically conductively connected to the data compression circuit (22), and wherein a compressed test signal (T[1]) is fed back to the test evaluation unit (12) by means of the test line (T1) for the purpose of checking the digital value of the test signal (T[1]).

2. Integrated circuit (1) according to Claim 1, wherein the control line (S1) comprises a first driver (D1) with a level converter.

3. Integrated circuit (1) according to either of the preceding claims, wherein the control line (S1) comprises a receiving circuit (L1) that is positioned upstream of the connection to the test line (T1).

4. Integrated circuit (1) according to one of the preceding claims, wherein the test line (T1) comprises a second driver (D2) with a level converter.

5. Integrated circuit (1) according to one of Claims 1 to 4, wherein the data compression circuit (22) comprises at least one logic gate.

6. Integrated circuit (1) according to one of Claims 1 to 5, wherein the data compression circuit (22) comprises at least one EXOR gate (E1,...,En,...,EN-1).

7. Integrated circuit (1) according to Claim 6, comprising N-1 EXOR gates (E1,...,En,...,EN-1) and where 1≤n≤N-1, wherein, for n≥2,
a first input of the n-th EXOR gate (En) is electrically conductively connected to the output of the (n-1)-th EXOR gate (En-1) and a second input of the n-th EXOR gate (En) is electrically conductively connected to the (n+1)-th control line (Sn+1), wherein, for n=1,
the first input of the 1st EXOR gate (E1) is electrically conductively connected to the 1st control line (S1) and the second input of the 1st EXOR gate (E1) is electrically conductively connected to the 2nd control line (S2), and wherein, for n=(N-1), the output of the (N-1)-th EXOR gate (EN-1) is also electrically conductively connected to the test line (T1) for feeding back the compressed test signal (T[1]).

8. Integrated circuit (1) according to one of the preceding Claims 1 to 7, wherein the analogue circuit (25) comprises a plurality of R data compression circuits (22-1,...,22-r,...,22-R), where R≥2, wherein every r-th data compression circuit (22-r), where 1≤r≤R, is electrically conductively connected to a plurality of control lines (SK,...,SL) and is designed to compress the control signals (S[K],...,S[L]) transmitted via these control lines (SK,...,SL) into an r-th test signal (T[r]) .

9. Integrated circuit (1) according to Claim 8, wherein the integrated circuit (1) also comprises a plurality of R test lines (T1,...,Tr,...,TR), wherein every r-th test line (Tr) is electrically conductively connected to the r-th data compression circuit (22-r) and feeds back compressed r-th test signals (T[r]) from the analogue circuit (25) to the test evaluation unit (12).

10. Application-specific integrated circuit, ASIC, which comprises an integrated circuit (1) according to one of Claims 1 to 9.

## Revendications

1. Circuit intégré (1), comprenant :
une zone de commutation numérique (10) comprenant un circuit numérique (15) ;
une zone de commutation analogique (20) physiquement séparée de la zone de commutation numérique (10) et qui comprend un circuit analogique (25) ;
une ligne de commande (S1) pour transmettre un signal de commande (S[1]) du circuit numérique (15) au circuit analogique (25) ;
une unité d'évaluation de test (12) qui est intégrée dans la zone de commutation numérique (10) ;
une ligne de test (T1) reliée de manière électriquement conductrice à la ligne de commande (S1) à l'intérieur de la zone de commutation analogique (20) et qui est reliée de manière électriquement conductrice à l'unité d'évaluation de test (12), dans lequel l'unité d'évaluation de test (12) est réalisée pour vérifier une valeur numérique d'un signal renvoyé par l'intermédiaire de la ligne de test,
**caractérisé en ce que** le circuit intégré (1) comprend N ≥ 2 lignes de commande (S1, ..., Sn, ..., SN) pour transmettre des signaux de commande respectifs (S[1], ... , S[n], ... , S[N]) du circuit numérique (15) au circuit analogique (25), dans lequel le circuit analogique (25) comprend en outre un circuit de compression de données (22) qui est réalisé pour comprimer des signaux de commande (S[1], ..., S[n], ..., S[N]) transmis par l'intermédiaire des lignes de commande (S1, ..., Sn, ..., SN) en un signal de test comprimé (T[1]), dans lequel la ligne de test (T1) est reliée de manière électriquement conductrice au circuit de compression de données (22), et dans lequel, au moyen de la ligne de test (T1), un signal de test comprimé (T[1]) est renvoyé (T[1]) à l'unité d'évaluation de test (12) pour une vérification de la valeur numérique du signal de test.

2. Circuit intégré (1) selon la revendication 1, dans lequel la ligne de commande (S1) comprend un premier circuit d'attaque (D1) muni d'un convertisseur de niveau.

3. Circuit intégré (1) selon l'une quelconque des revendications précédentes, dans lequel la ligne de commande (S1) comprend un circuit de réception (L1) positionné en amont de la liaison avec la ligne de test (T1) .

4. Circuit intégré (1) selon l'une quelconque des revendications précédentes, dans lequel la ligne de test (T1) comprend un deuxième circuit d'attaque (D2) muni d'un convertisseur de niveau.

5. Circuit intégré (1) selon l'une quelconque des revendications 1 à 4, dans lequel le circuit de compression de données (22) comprend au moins une porte logique.

6. Circuit intégré (1) selon l'une quelconque des revendications 1 à 5, dans lequel le circuit de compression de données (22) comprend au moins une porte EXOR (E1, ..., En, ..., EN-1).

7. Circuit intégré (1) selon la revendication 6, comprenant N-1 portes EXOR (E1, ..., En, ..., EN-1) et 1 ≤ n ≤ N-1, dans lequel pour n ≥ 2,
une première entrée de la porte EXOR n (En) est reliée de manière électriquement conductrice à la sortie de la porte EXOR n-1 (En-1), et une deuxième entrée de la porte EXOR n (En) est reliée de manière électriquement conductrice à la ligne de commande n+1 (Sn+1), dans lequel pour n = 1,
la première entrée de la porte EXOR 1 (E1) est reliée de manière électriquement conductrice à la ligne de commande 1 (S1), et la deuxième entrée de la porte EXOR 1 (E1) est reliée de manière électriquement conductrice à la ligne de commande 2 (S2), et dans lequel pour n = (N-1), en outre la sortie de la porte EXOR N-1 (EN-1) est reliée de manière électriquement conductrice à la ligne de test (T1) pour renvoyer le signal de test comprimé (T([1]).

8. Circuit intégré (1) selon l'une quelconque des revendications précédentes 1 à 7, dans lequel le circuit analogique (25) comprend une pluralité de R circuits de compression de données (22-1, ... , 22-r, ... , 22-R), où R ≥ 2, dans lequel chaque circuit de compression de données r (22-r), où 1 ≤ r ≤ R est relié de manière électriquement conductrice à une pluralité de lignes de commande (SK, ..., SL), et est réalisé pour comprimer les signaux de commande (S[K], ... , S[L]) transmis par l'intermédiaire de ces lignes de commande (SK, ..., SL) en un signal de test r (T[r]).

9. Circuit intégré (1) selon la revendication 8, dans lequel le circuit intégré (1) comprend en outre une pluralité de R lignes de test (T1, ..., Tr, ..., TR), dans lequel chaque ligne de test r (Tr) est relié de manière électriquement conductrice au circuit de compression de données r (22-r) et renvoie des signaux de test r (T[r]) comprimés du circuit analogique (25) à l'unité d'évaluation de test (12).

10. Circuit intégré spécifique à une application, ASIC, qui comprend un circuit intégré (1) selon l'une quelconque des revendications 1 à 9.
